# EUROPÄISCHE PATENTSCHRIFT

(11) **EP 0 377 619 B1**
(45) Veröffentlichungstag und Bekanntmachung des Hinweises auf die Patenterteilung: **09.03.1994**
(21) Anmeldenummer: 88907628.7
(22) Anmeldetag: 16.09.1988
(51) Int. Cl.: F02P 7/073, H03K 17/78, H03K 17/10, G02B 6/42

(54) **HOCHSPANNUNGSSCHALTER UND VERFAHREN ZUR ANSTEUERUNG VON VERBRAUCHERN MITTELS DES HOCHSPANNUNGSSCHALTERS**
HIGH-VOLTAGE SWITCH AND METHOD TO CONTROL USER CIRCUITS BY MEANS OF THIS SWITCH
COMMUTATEUR A HAUTE TENSION ET PROCEDE DE COMMANDE DE CIRCUITS D'UTILISATION AU MOYEN D'UN TEL COMMUTATEUR

(30) Priorität: 18.09.1987 DE 3731412
(43) Veröffentlichungstag der Anmeldung: 18.07.1990
(73) Patentinhaber: ROBERT BOSCH GMBH, 70442 Stuttgart (DE)
(72) Erfinder: HERDEN, Werner, D-7016 Gerlingen (DE); BENEDIKT, Walter, D-7014 Kornwestheim (DE); KRAUTER, Immanuel, D-7151 Erbstetten (DE)
(86) Internationale Anmeldenummer: DE8800573
(87) Internationale Veröffentlichungsnummer: WO8902527

(56) Entgegenhaltungen:
- WO-A-88/03608
- GB-A- 2 136 238
- US-A- 4 274 135

## Beschreibung

Die Erfindung betrifft einen Hochspannungsschalter und ein Verfahren zur Ansteuerung von Verbrauchern mittels eines Hochspannungsschalters gemaß der Gattung der Ansprüche 1 bzw. 4.

Es sind vollelektronische Zündanlagen für Verbrennungsmotoren bekannt, bei denen nicht nur die Zündauslösung und die Zündwinkelbestimmung elektronisch erfolgen, sondern auch die Verteilung und Übertragung des Zündfunkens an die Zündkerze des richtigen Zylinders. Bei diesen Anlagen wird also die Hochspannung nicht mehr durch mechanische rotierende Teile sondern durch statisch arbeitende, elektronisch angesteuerte Komponenten verteilt. Es liegt folglich eine statische oder ruhende Hochspannungsverteilung vor. Bei diesen Anlagen ist für jede Zündkerze je eine Zündspule und je ein Abschalttransistor vorgesehen. Dadurch sind die Anlagen nicht nur sehr schwer und teuer, sondern auch relativ aufwendig. Sie haben überdies einen großen Platzbedarf. Aus der WO 88/03608 ist ein Hochspannungsschalter, der insbesondere als Zündspannungsverteiler zum Anlagen der Zündspannung an Zündkerzen eines Verbrennungsmotors verwendbar ist, bekanntgeworden wobei der Hochspannungsschalter aus einer Kaskadenschaltung von optoelektrischen Halbleiterelementen besteht, die mittels Lichteinstrahlung betätigt bzw. durchgeschaltet werden. Dadurch lassen sich sehr hohe Spannungen exakt schalten, wobei zwischen Steuerkreis und Hochspannungskreis eine galvanische Trennung gegeben ist. Der Steuerkreis läßt sich mit jeder Spannung betreiben, so daß eine Anwendung in Verbindung mit elektronischen Zündanlagen problemlos ist. Aus der GB-A 21 36 238 ist eine Schalteinrichtung bekannt, wobei ein optisches Signal mittels einer optischen Leitung an den Schalttransistor angekoppelt wird. Schließlich ist aus der US-A 4,274,135 eine Steuerschaltung für einen Hochspannungsthyristor bekanntgeworden, wobei die Schaltsignale über Lichtleiter zugeführt werden.

Der Hochspannungsschalter mit den kennzeichnenden Merkmalen des Anspruchs 1 hat demgegenüber den Vorteil, daß der Verlauf der an einem Hochspannungsverbraucher, insbesondere der Zündkerze, anliegenden Spannung durch einen Aufsteilerungseffekt verbessert wird, so daß Nebenschlüsse nicht zu einer Fehlfunktion des Verbrauchers führen, beispielsweise zu Zündaussetzern. Dabei wird der Effekt ausgenutzt, daß sich bei spannungsgesteuerten Halbleiterelementen der Sperrstrom und der Fotostrom zum Triggerstrom addieren. Der Sperrstrom ist umso höher, je höher die anliegende Spannung ist. Bei hoher anliegender Spannung ist folglich die Lichtleistung, die zum Triggern bzw. Durchschalten der Kaskade nötig ist, geringer als bei niedriger anliegender Spannung. Durch Einstellung der angebotenen Lichtleistung kann also die Spannung eingestellt werden, bei welcher die Kaskade durchbricht, d.h. welcher Aufsteilerungseffekt erzielt wird. Auf Verunreinigungen beruhende Nebenschlüsse können so nicht zu einer Fehlfunktion des angeschlossenen Verbrauchers führen.

Durch die Unteransprüche 2 und 3 sind vorteilhaft Weiterbildungen und Verbesserungen des Schalters gemäß Anspruch 1 möglich. Besonders verteilhaft ist es, die Kaskadenschaltungen und die lichtemittierenden
Elemente gemeinsam mit Schutzbauelementen in integrierten Schaltkreisen zu integrieren. Dadurch wird eine besonders preisgünstige Herstellung des Hochspannungsschaltes ermöglicht. Durch das Ansteuerungsverfahren gemaß Anspruch 4 wird erreicht, daß das Durchschalten der Kaskade nicht durch die Ansteuerung der lichtemittierenden Elemente erfolgt, sondern dann, wenn die durch die Anzahl der nicht angesteuerten Halbleiterelemente vorgewählte Kippspannung erreicht wird und diese schlagartig leitend schalten. Dadurch ergibt sich eine sehr schnelle Anstiegszeit beim Schaltvorgang. Durch die Variation der den lichtemittierenden Elementen zugeführten Lichtleistung kann zudem eine Veränderung der vorgewählten Kippspannung erreicht werden, indem die an der Kaskadenschaltung anliegende Spannung durch Variation der Lichtleistung verändert wird. Hierdurch ist der Einsatzpunkt des Aufsteilerungseffektes sehr genau vorwählbar.

Die Erfindung wird im folgenden anhand der Zeichnung näher erläutert. Hierbei stellen die Ausführungsarten gemäß den Figuren 1 bis 7 nicht Ausführungsarten der Erfindung dar, sondern es handelt sich um Beispiele, die das Verständnis der Erfindung erleichtern. Es zeigen:
Figur 1 einen als Zündverteileranordnung ausgebildeten Hochspannungsschalter;
Figur 2 das Prinzip eines Hochspannungsschalters mit Lichtleitfasern;
Figur 3 einen Hochspannungsschalter mit mehreren Darlington-Schaltungen und mit separaten Licht emittierenden Elementen;
Figur 4 eine in Hybridtechnik aufgebaute Schaltungsanordnung eines Hochspannungsschalters im Schnitt; Figur 5 einen Zündschaltung mit Hochspannungsschalter;
Figur 6 einen Hochspannungsschalter mit in Kaskade angeordneten Thyristoren;
Figur 7 ein Diagramm des Spannungsverlaufs an der Sekundärseite der Zündspule (durchgezogene Linie) und an einer von einem Hochspannungsschalter angesteuerten Zündkerze (gestrichelte Linie) und
Figur 8 einen Hochspannungsschalter mit einer Kombination aus spannungsgesteuerten und lichtgesteuerten Halbleiterelementen.

Ein Hochspannungsschalter der eingangs genannten Art ist grundsätzlich beliebig einsetzbar zwischen einer Hochspannungsquelle und einem Hochspannungsverbraucher. Im folgenden soll die Verwendung in einem ruhenden Hochspannungsverteiler einer Brennkraftmaschine mit 4 Zylindern beschrieben werden.

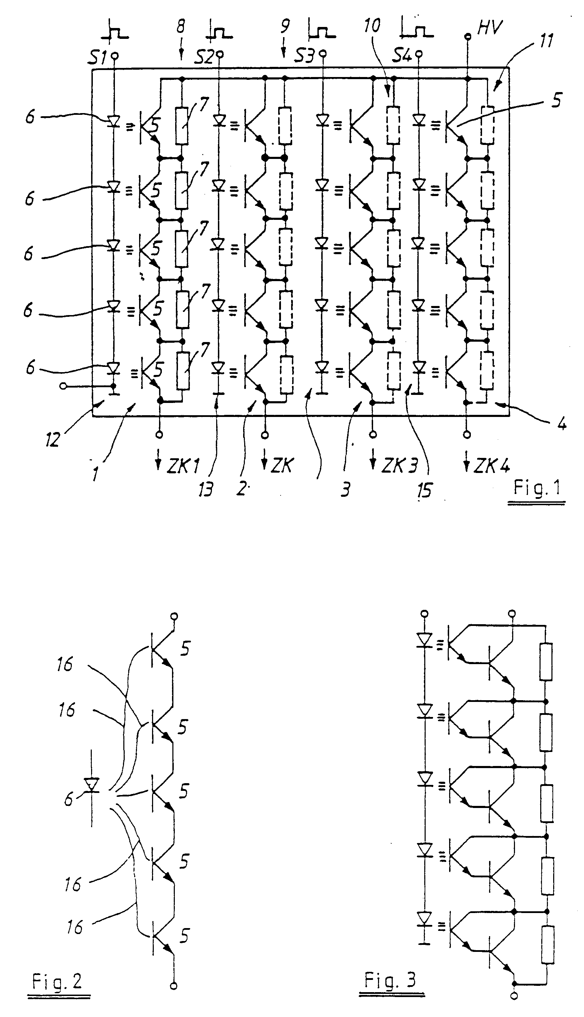

Figur 1 zeigt eine Schaltungsanordnung eines Zündspannungsverteilers, der 4 Kaskadenschaltungen 1 bis 4 enthält, die jeweils aus optoelektronischen Halbleiterelementen bestehen, die hier als Hochspannungs-Phototransistoren 5 ausgebildet sind. Jedem der Hochspannungs-Phototransistoren 5 ist ein als Leuchtdiode 6 ausgebildetes Licht emittierendes Element zugeordnet. Jeweils einem der Transistoren ist ein Widerstand 7 parallel geschaltet. Diese bilden Spannungsteiler 8 bis 11, die zur Linearisierung der Kaskadenschaltungen 1 bis 4 dienen. Die kollektorseitigen Anschlüsse der Kaskadenschaltungen sind mit einem Hochspannungseingang HV verbunden, während die Emitter der letzten Elemente der Kaskadenschaltungen jeweils mit einer hier nicht dargestellten Zündkerze ZK1 bis ZK4 verbunden sind. Den Kaskadenschaltungen 1 bis 4 sind Reihenschaltungen 12 bis 15 von Leuchtdioden 6 zugeordnet, die über Steuereingänge S1 bis S4 ansteuerbar sind. Wird einer der Steuereingänge S1 bis S4 mit einem Steuersignal angesteuert, so emittieren die Leuchtdioden 6 Licht, welches auf die lichtempfindliche Zone des jeweils zugeordneten Transistors 5 fällt. Dadurch wird die zugehörige Kaskadenschaltung durchgeschaltet, so daß die am Hochspannungseingang HV anliegenden Hochspannungsimpulse von beispielsweise 15 bis 40 kV an die zugehörige Zündkerze angelegt wird.

Figur 2 zeigt ein Prinzipschaltbild eines Hochspannungsschalters, der eine Kaskade von 5 Hochspannungs-Phototransistoren 5 aufweist, die von einer einzigen Leuchtdiode 6 angesteuert werden. Das Licht der Leuchtdiode 6 wird den lichtempfindlichen Bereichen der Phototransistoren über Lichtleitfasern 16 zugeführt.

Figur 3 zeigt einen weiteren Hochspannungsschalter, bei dem an Stelle der einzelnen Phototransistoren der Kaskadenschaltung jeweils eine Darlington-Schaltung vorgesehen ist, die jeweils aus einem Transistor und einem Phototransistor besteht. Parallel zu jeder Darlington-Schaltung liegt ein Widerstand. Den dadurch entstehende Spannungsteiler dient wiederum zur Linearisierung der Kaskadenschaltung. Das Ausführungsbeispiel gem. Figur 3 ist besonders für hohe Zündströme und für niedrige Lichtleistungen geeignet.

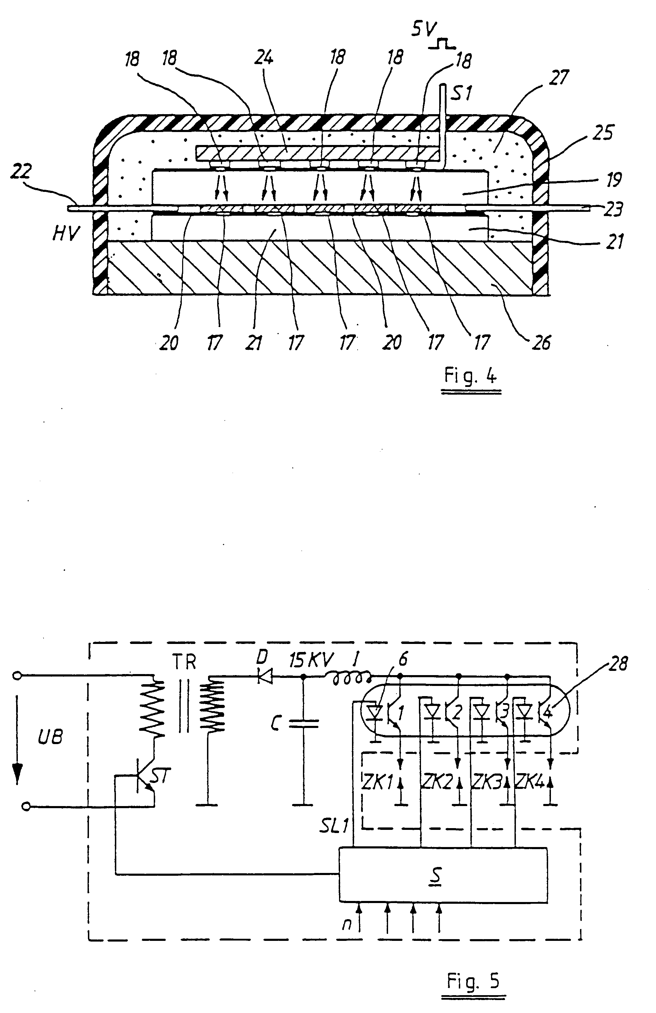

Figur 4 zeigt einen Schnitt durch einen in Hybridtechnik aufgebauten Hochspannungsschalter, der 5 optoelektronische Halbleiterelemente 17 aufweist, denen 5 Leuchtdioden 18 zugeordnet sind. Zwischen den Dioden 18 und den Halbleiterelementen 17 befindet sich eine als lichtdurchlässiger Isolator dienende Glasschicht 19. Die Halbleiterelemente 17 sind über Leiterbahnen und Widerstandsnetzwerke 20 miteinander verbunden und über einen Träger-Substrat 21 angeordnet. Die Leiterbahnen 20 sind elektrisch leitend mit Hochspannungs-Anschlußfahnen 22, 23 verbunden, wobei eine der Anschlußfahnen den Hochspannungsanschluß HV und die andere der Anschlußfahnen den zu einer Zündkerze führenden Anschluß darstellen kann.

Oberhalb der Leuchtdioden 18 befindet sich eine Wärmeleitschicht 24, die beispielsweise aus Aluminium bestehen kann und der Wärmeableitung dient. Der Steueranschluß S1 für die Leuchtdioden 18 ist bei dem hier dargestellten Ausführungsbeispiel oben aus dem Gehäuse 25 herausgeführt. Dieses besteht beispielsweise aus Kunststoff und ist unten mit einem Deckel 26, beispielsweise aus Aluminium verbunden. Das Innere des Gehäuses ist mit einer Vergußmasse 27 ausgegossen, wodurch eine optimale Isolierung erreicht wird.

Figur 5 zeigt eine Zündanlage eines Verbrennungsmotors mit vier Zylindern bzw. Zündkerzen ZK1 bis ZK4. Die Hochspannungsschalter sind wie in Figur 1 als Kaskadenschaltungen 1 bis 4 ausgebildet, wobei zur Vereinfachung hier lediglich jeweils ein Transistorelement mit einer zugehörigen Leuchtdiode 6 dargestellt ist.

In Figur 5 ist eine Hochspannungs-Kondensatorzündanlage dargestellt. Die Verwendung des Hochspannungsschalters ist nicht auf derartige Zündanlagen beschränkt, er ist vielmehr auch mit einer Zündspule, einer Transistorzündung kombinierbar, worauf unten genauer eingegangen wird.

Die in Figur 5 durch eine gestrichtelte Linie umrissene Zündanlage weist einen Transformator TR mit einer Primärwicklung auf, die über einen Schalttransistor ST mit einer Batteriespannung UB verbunden ist. Die Basis des Schalttransistors ist mit einem Steuergerät S verbunden. Zur Erzeugung einer sekundärseitigen Hochspannung am Transformator TR wird der Schalttransistor von dem Steuergerät S z.B. mit einer Frequenz von 500 Hz aus- und eingeschaltet. Die Sekundärwicklung des Transistors liegt einerseits an Masse und ist andererseits über eine Diode D und eine Induktivität I mit der Kaskadenschaltung 28 verbunden. Die Kathode der Diode D liegt an der Sekundärwicklung, ihre Anode an einem ersten Anschluß eines Hochspannungs-Kondensators C, dessen zweiter Anschluß an Masse liegt. Der Hochspannungs-Kondensator C wird von dem Transformator TR über die Diode D aufgeladen, beispielsweise auf eine Gleichspannung von 25 kV.

Die Steuerung S ermittelt für jede Zündkerze ZK1 bis ZK4 den optimalen Zündzeitpunkt in Abhängigkeit von verschiedenen, den jeweiligen Betriebszustand des Motors kennzeichnenden Parametern. Dabei werden unter anderem beispielsweise die Last und die Drehzahl n des Motors berücksichtigt. Soll beispielsweise die Zündkerze ZK1 zünden, so wird die Leuchtdiode 6 der Kaskadenschaltung 1 von der Steuerung S über eine Steuerleitung SL1 angesteuert. Durch das Licht der Diode wird die Kaskadenschaltung 1 durchgeschaltet, so daß die am Hochspannungs-Kondensator C liegende Hochspannung zur Zündkerze ZK1 gelangt. Entsprechend werden die übrigen Zündkerzen ZK2 bis ZK4 zum berechneten Zündzeitpunkt mit der Zündspannung beaufschlagt.

Die in der Kaskadenschaltung 28 vorgesehenen Leuchtdioden 6 können auch in der Steuerung S untergebracht sein. Die Kaskadenschaltungen sind dann, wie in Figur 2 dargestellt, über Lichtleitfasern mit dem Steuergerät verbunden.

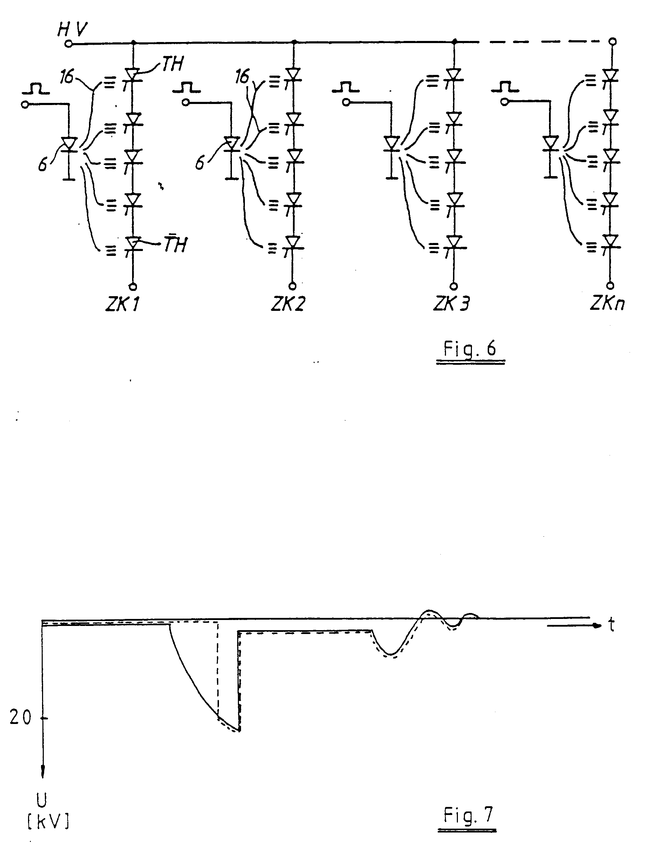

Figur 6 zeigt weitere Hochspannungsschalter, die aus Photo-Thyristoren TH ausgebildet sind, die über Lichtleitfasern 16 jeweils mit einer Leuchtdiode 6 optisch gekoppelt sind. Es ist natürlich auch möglich, jedem der Thyristoren eine eigene Leuchtdiode 6 zuzuordnen. Es ist ersichtlich, daß die Schaltung für eine beliebige Anzahl von Zündkerzen ZK1 bis ZKn verwendbar ist. Dies gilt auch für die in den übrigen Figuren dargestellten Schaltungen.

Es ist auch möglich, Hochspannungsschalter als Photo-IC's auszubilden. Diese IC's bestehen aus Photodioden oder Phototransistoren sowie verstärkenden Transistoren oder Thyristoren in Darlingtonschaltungen sowie aus Bauteilen, die das Durchschalten bei hohen Spannungsanstiegsgeschwindigkeiten ohne Licht verhindern.
in der Schaltung gem. Figur 5 liegt die volle Zündspannung am Hochspannungsschalter an, wenn dieser vom Steuergerät durchgeschaltet wird.

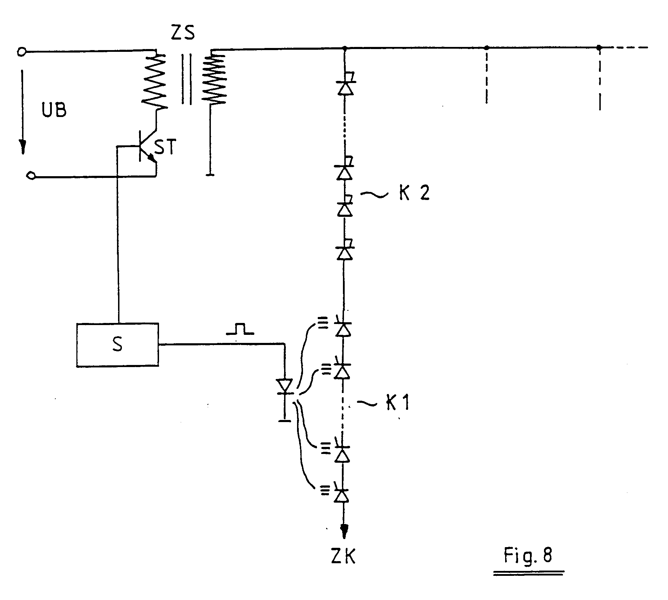

Werden dagegen Hochspannungsschalter der oben beschriebenen Art mit Transistorzündanlagen nach Figur 6 kombiniert, so liegen am Hochspannungseingang HV der Kaskadenschaltungen die auf der Sekundärseite einer Zündspule erzeugten Spannungsimpulse an. Der Verlauf dieser Spannungsimpulse ist mit einer durchgezogenen Linie in Figur 7 dargestellt. Die Zündspannung von beispielsweise 20 kV wird nach einer Anstiegszeit von beispieisweise 40 µs erreicht. Wenn der Hochspannungsschalter während dieser Zeit durchgeschaltet ist, können sich beispielsweise auf Verrußung der Zündkerzen beruhende Nebenschlüsse so auswirken, daß Energie abfließt. Das kann dazu führen, daß die Zündspannung nicht erreicht wird und sog. Zündaussetzer auftreten. Dies wird dadurch verhindert, daß die Leuchtdioden 6 verzögert angesteuert werden. Dadurch gelangt die Halbleiterkaskade erst dann in leitenden Zustand, wenn die Zündspannung am Hochspannungseingang der Kaskaden schon z.B. 20 kV erreicht hat. Wird die Zündspannung erst in diesem Moment an die Zündkerzen angelegt, so können sich Nebenschlüsse nicht auswirken und es tritt unmittelbar ein Funke ein. Eine die Leuchtdioden ansteuernde Steuerung S, wie sie beispielsweise in Figur 8 dargestellt ist, muß in diesem Fall so ausgelegt sein, daß nach definierter Verzögerung nach Ansteuerung der Basis des Schalttransistors die Leuchtdioden 6 angesteuert werden. Es läßt sich damit eine sehr kurze Anstiegszeit von mehreren zehn bis hundert ns, beispielsweise von 50 ns erreichen, wie dies die gestrichelte Kurve in Figur 7 zeigt.

Ein derartiger Aufsteilerungseffekt läßt sich bei Kaskadenschaltungen aus Thyristoren in Verbindung mit Leuchtdioden erreichen, deren Lichtintensität so gewählt ist, daß die Photothyristorkaskade erst bei einer bestimmten an der Eingangsklemme HV liegenden Eingangsspannung von beispielsweise 20 kV durchschaltet. Dabei wird der Effekt ausgenützt, daß sich bei Thyristoren Sperrstrom und Photostrom zum Triggerstrom addieren. Der Sperrstrom ist umso höher, je höher die anliegende Spannung ist. Bei hoher anliegender Spannung ist folglich die Lichtleistung, die zum Triggern bzw. Durchschalten der Kaskade nötig ist, geringer als bei niedriger anliegender Spannung. Durch Einstellung der angebotenen Lichtleistung kann also die Spannung eingestellt werden, bei welcher die Kaskade durchschaltet. Im vorliegenden Fall wird die Lichtleistung der Leuchtdioden 6 so gewählt, daß erst bei Erreichen der Zündspannung von beispielsweise 20 kV eine Durchschaltung der Kaskade erfolgt. Dadurch wird die Anstiegszeit wiederum auf einen Wert von etwa 50 ns abgekürzt, so daß auf Verunreinigungen beruhende Nebenschlüsse sich nicht auswirken können.

In Figur 8 ist der erfindungsgemäße Hochspannungsschalter dargestellt. Er besteht aus zwei Halbleiter-Kaskadenschaltungen, die zwischen der Zündspule ZS einer Transistorzündanlage und einer Zündkerze ZK liegen. Die eine Halbleiterkaskade K1 wird von optoelektronischen Halbleiterelementen der oben beschriebenen Art gebildet, denen jeweils eine oder mehrere Leuchtdioden zugeordnet sind. Es sind hier sowohl Photothyristoren wie -Transistoren oder Photo-IC's verwendbar. Die andere Halbleiterkaskadenschaltung K2 ist aus Thyristoren oder Kippdioden zusammengesetzt, die bei einer vorgegebenen Kippspannung schlagartig aus dem sperrenden in den leitenden Zustand übergehen. Die Sperrspannung der einzelnen Thyristoren oder Kippdioden ist je nach Bauart verschieden. Bei einer Sperrspannung von beispielsweise 1 kV wird für eine Kippspannung von z.B. 20 kV eine aus 20 Elementen zusammengesetzte Kaskadenschaltung gewählt. Die Kaskadenschaltung aus optoelektronischen Halbleiterelementen und Kippdiodenelementen ist so ausgelegt, daß sie im unbeleuchteten Zustand für die Zündspannung undurchlässig ist.

Soll eine Zündkerze zünden, so werden die Leuchtdioden vor dem Anstieg des Zündspannungsimpulses eingeschaltet, so daß die photoelektronischen Halbleiterelemente in den leitenden Zustand geraten. Dadurch kann an diesen keine Spannung abfallen. Die von der Zündspule gelieferte Spannung fällt dadurch ausschließlich an den unbeleuchteten Thyristoren oder Kippdioden ab. Sobald die durch die Anzahl der Halbleiterelemente vorgewählte Kippspannung von beispielsweise 20 kV erreicht wird, gelangen diese schlagartig in den leitenden Zustand. Die Anstiegszeit der an der zugehörigen Zündkerze liegenden Spannung liegt bei mehreren zehn bis hundert ns, etwa bei 50 ns. Durch diesen Aufsteilerungseffekt können sich beispielsweise auf Ruß beruhende Nebenschlüsse nicht auswirken.

Die Kaskade der unbeleuchteten Halbleiterelemente kann nicht nur aus Kippdioden und unsymmetrischen Thyristoren bestehen, es können auch, um den positiven Einschaltimpuls der Zündspule abzublocken, auch symmetrische Thyristoren Verwendung finden. Am geeignetsten sind Bauteile mit Vertikalstruktur, da diese, ähnlich wie bei der Herstellung von Hochspannungsdioden, aufeinandergestapelt und als Stapel vergossen werden können.

Anstelle der beschriebenen Leuchtdioden können hier beliebige Licht emittierende Elemente verwendet werden. Mit Niederspannung betreibbare Bauteile werden jedoch bevorzugt.

Das Ausführungsbeispiel gem. Figur 8 hat den Vorteil, daß teure photoelektronische Bauteile eingespart werden können. Wenn die Sperrspannung der unbeleuchteten Schaltelemente auf die Zündspannung ausgeiegt ist, so braucht die Anzahl der photoelektronischen Halbleiterelemente nur so gewählt werden, daß die Sperrspannung aller Halbleiterelemente des Hochspannungsschalters so hoch ist, daß die maximale an der Zündspule auftretende Spannung gesperrt wird. Überdies kann der Elnsatzpunkt des Aufsteilerungseffekts durch die Anzahl der unbeleuchteten Halbleiterelemente sehr genau vorgewählt werden. Er wird durch die Summe der Kippspannungen der Einzelbauteile bestimmt, die nur geringfügig von der Temperatur und der Lebensdauer der Halbleiterkaskade abhängt.

Aus dem oben Gesagten ergibt sich, daß der beschriebene Hochspannungs-Halbleiterschalter überall dort eingesetzt werden kann, wo eine galvanische Trennung zwischen Steuerkreis und Hochspannungskreis gewünscht oder erforderlich ist.

## Patentansprüche

1. Hochspannungsschalter, insbesondere Zündspannungsschalter zum Anlegen der Zündspannung an Zündkerzen eines Verbrennungsmotors, mit mindestens einer aus wenigstem einem optoelektronischen Halbleiterelement bestehenden Kaskadenschaltung (1 bis 4), der jeweils mindestens ein lichtemittierendes Element (6) zum Durchschalten der zugehörigen Kaskadenschaltung zugeordnet ist, dadurch gekennzeichnet, daß jeder aus wenigstens einem optoelektronischen Halbleiterbauelementen (K1) bestehenden Kaskadenschaltung (1 bis 4) eine Kaskadenschaltung aus spannungsgesteuerten Halbleiterelementen (K2) in Reihe geschaltet ist.

2. Hochspannungschalter nach Anspruch 1, dadurch gekennzeichnet, daß die spannungsgesteuerten Halbleiterelemente (K2) als Kippdioden oder Thyristoren ausgebildet sind.

3. Hochspannungsschalter nach einem der Ansprüche 1 oder 2, dadurch gekennzeichnet, daß die Kaskadenschaltungen und die lichtemittierenden Elemente (6) gemeinsam mit Schutzbauelementen in integrierten Schaltkreisen integrierbar sind.

4. Verfahren zur Ansteuerung von Hochspannungsverbrauchern, insbesondere von Zündkerzen eines Verbrennungsmotors, mit Hilfe eines Hochspannungsschalters nach einem der vorhergehenden Ansprüche, dadurch gekennzeichnet, daß die lichtemittierenden Elemente angesteuert werden, bevor an der Kaskadenschaltung (1 bis 4) die Zündspannungsimpulse anliegen.

5. Verfahren zur Ansteuerung von Hochspannungsverbrauchern, insbesondere von Zündkerzen eines Verbrennungsmotors, mit Hilfe eines Hochspannungsschalters mit mindestens einer aus wenigstens einem optoelektronischen Halbleiterelement bestehenden Kaskadenschaltung (1 bis 4), der jeweils mindestens ein lichtemmittierendes Element (6) zum Durchschalten der zugehörigen Kaskadenschaltung zugeordnet ist, dadurch gekennzeichnet, daß die Lichtleistung der lichtemittierenden Elemete (6) so niedrig gewählt wird oder die lichtemittierenden Elemente (6) verzögert so angesteuert werden, daß die an der Kaskadenschaltung anliegende Spannung zuvor einen vorgegebenen Wert erreicht.

## Claims

1. High-voltage switch, especially an ignition-voltage switch for applying the ignition voltage to spark plugs in an internal-combustion engine, having at least one cascade circuit (1 to 4) which consists of at least one optoelectronic semiconductor element and to which in each case at least one light-emitting element (6) is allocated for switching through the associated cascade circuit, characterized in that a cascade circuit consisting of voltage-controlled semiconductor elements (K2) is connected in series with each cascade circuit (1 to 4) which consists of at least one optoelectronic semiconductor element (K1).

2. High-voltage switch according to Claim 1, characterized in that the voltage-controlled semiconductor elements (K2) are configured as breakover diodes or thyristors.

3. High-voltage switch according to one of Claims 1 or 2, characterized in that the cascade circuits and the light-emitting elements (6) can be integrated together with protection components in integrated circuits.

4. Method for driving high-voltage loads, especially spark plugs in an internal-combustion engine, with the aid of a high-voltage switch according to one of the preceding claims, characterized in that the light-emitting elements are driven before the ignition voltage pulses are applied to the cascade circuit (1 to 4).

5. Method for driving high-voltage loads, especially spark plugs in an internal-combustion engine, with the aid of a high-voltage switch having at least one cascade circuit (1 to 4) which consists of at least one optoelectronic semiconductor element and to which in each case at least one light-emitting element (6) is allocated for switching through the associated cascade circuit, characterized in that the light power of the light-emitting elements (6) is selected to be so low, or the light-emitting elements (6) are driven in a delayed manner, such that the voltage applied to the cascade circuit reaches a predetermined value in advance.

## Revendications

1. Commutateur à haute tension notamment commutateur de tension d'allumage pour appliquer la tension d'allumage aux bougies d'un moteur à combustion interne, avec au moins un circuit en cascade (1-4) composé d'au moins un composant semi-conducteur opto-électronique, auquel est associé au moins un élément photo-émetteur (5) pour débloquer le circuit en cascade correspondant, caractérisé en ce que chaque circuit en cascade (1-4), formé d'au moins un composant semi-conducteur opto-électronique (K1), est branché en série avec un circuit en cascade formé de composants semi-conducteurs commandés en tension (K2).

2. Commutateur à haute tension selon la revendication 1, caractérisé en ce que les composants semi-conducteurs commandés en tension (K2) sont des diodes à basculement ou des thyristors.

3. Commutateur à haute tension selon l'une des revendications 1 ou 2, caractérisé en ce que les montages en cascade et les éléments photo-émetteurs (6) sont intégrés en commun aux composants de protection dans les circuits intégrés.

4. Procédé de commande de circuit utilisateur de haute tension notamment des bougies d'allumage d'un moteur à combustion interne à l'aide d'un commutateur à haute tension selon l'une des revendications précédentes, caractérisé en ce que les éléments photoémetteurs sont commandés avant l'application de l'impulsion de tension d'allumage au circuit en cascade (1-4).

5. Procédé de commande de circuit utilisateur de haute tension notamment des bougies d'un moteur à combustion interne à l'aide d'un commutateur à haute tension avec au moins un circuit en cascade (1-4) formé d'au moins un composant semi-conducteur optoélectronique auquel est associé au moins un élément photo-émetteur (6) pour débloquer le circuit en cascade correspondant, procédé caractérisé en ce que la puissance optique des éléments photo-émetteurs (6) est choisie suffisamment faible où les éléments photoémetteurs (6) sont commandés avec retard pour que la tension appliquée au circuit en cascade ait atteint préalablement une valeur prédéterminée.
